# EUROPÄISCHE PATENTSCHRIFT

(11) **EP 1 325 538 B1**
(45) Veröffentlichungstag und Bekanntmachung des Hinweises auf die Patenterteilung: **21.04.2004**
(21) Anmeldenummer: 01965238.7
(22) Anmeldetag: 31.08.2001
(51) Int. Cl.: H01R 4/02, H01R 12/08, H01R 43/02

(54) **VERFAHREN ZUM VERBINDEN VON FLACHEN FOLIENKABELN**
METHOD FOR CONNECTING FLAT FILM CABLES
PROCEDE DE CONNEXION DE CABLES PLATS

(30) Priorität: 13.10.2000 DE 10050798
(43) Veröffentlichungstag der Anmeldung: 09.07.2003
(73) Patentinhaber: DaimlerChrysler AG, 70567 Stuttgart (DE)
(72) Erfinder: KANBACH, Helmut, 63500 Seligenstadt (DE)
(74) Vertreter: Scheidt, Martin
(86) Internationale Anmeldenummer: PCT/EP2001/010050
(87) Internationale Veröffentlichungsnummer: WO 2002/031922

(56) Entgegenhaltungen:
- EP-A- 0 371 646
- US-A- 5 673 480

## Beschreibung

Die Erfindung betrifft ein Verfahren mit den Merkmalen des unabhängigen Anspruchs.

Im Kraftfahrzeugbau werden immer häufiger sogenannte Flat Laminated Cables oder FLC's eingesetzt. Der englische Fachbegriff hat international Verbreitung gefunden. In der vorliegenden Erfindung werden diese Flat Laminated Cables als Folienkabel bezeichnet. Unter Folienkabeln werden demnach Flachkabel verstanden, bei denen eine Viellzahl paralleler folienartiger Leiterbahnen zwischen zwei isolierenden Kunststofflaminaten angeordnet sind. Das sichere und dauerhafte Verbinden zweier Folienkabelenden ist Inhalt der hier beschriebenen Erfindung.

In der JP 07326404 A, Patent Abstracts of Japan (CD-ROM), Vol.95, No.12 hat man zum Verbinden von Folienkabeln vorgeschlagen, an den Kabelenden in das Kunststofflaminat elektrisch leitendes Pulver einzulagern. Die Folienkabel werden zum Verbinden an ihren Enden paßgenau übereindergelegt, so daß die Leiterbahnen des einen Kabel über den Leiterbahnen des anderen Kabel zu liegen kommen. Dann werden die Kabelenden aufeinander gedrückt und erhitzt, so daß das Kunststofflaminat über den Leiterbahnen örtlich aufschmilzt und das eingelagerte Metallpulver den elektrischen Kontakt zwischen den zugeordneten Leiterbahnen herstellt.

In der JP 11149951 A, Patent Abstracts of Japan 1999, wird vorgeschlagen die Enden von Folienkabel vorzukonfektionieren, um ein Verbinden zweier Folienkabel zu ermöglichen. Die Folienkabelenden werden einseitig abisoliert, so daß die Leiterbahnen nackt aus den Foliensubstraten hervorstehen. Zudem werden die Leiterbahnen an den Enden des Folienkabels gegenüber der Längsrichtung des Folienkabels näherungsweise um einen Winkel von 45° abgewickelt. Hierdurch überkreuzen sich beim Übereinanderlegen der abisolierten Seiten zweier Folienkabelenden die Leiterbahnen des ersten Folienkabels mit den Leiterbahnen des zweiten Folienkabels. Durch die Überkreuzung der Leiterbahnen müssen die beiden Folienkabel nicht genau flüchtig ausgerichtet werden, um die Leiterbahnen miteinander verbinden zu können.

Zur Verkabelung von elektrischen Geräten in Kraftfahrzeugen sind diese Verbindungsverfahren nur geeignet, wenn die Länge des Folienkabels vorkonfektioniert ist. Muß die Länge des Folienkabels nur geringfügig gekürzt werden oder wird ein längeres Folienkabel benötigt, können die Enden der Folienkabel nach den vorbeschriebenen Verfahren nicht mehr verbunden werden.

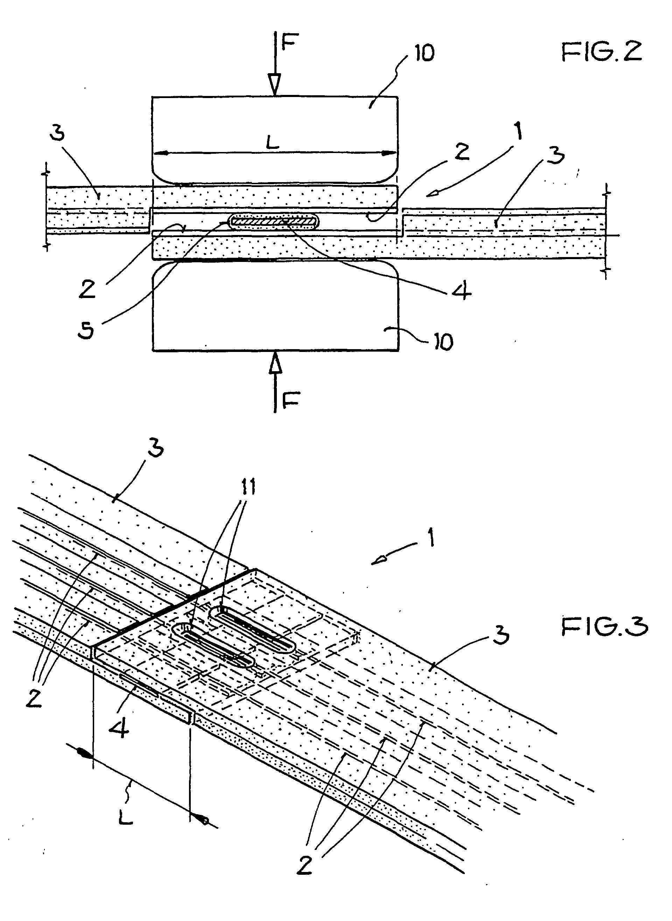

EP-A-0371646, beschreibt ein "Verfahren zum Verbinden eines Kabelendes (50) mit einem PCB (45), in denen in das Kabelende in einem Kunststofflaminat eine Vielzahl von Leiterbahnen (51) angeordnet sind, umfassend:
a) einen vorbereitenden Verfahrensschritt, bei dem im Überlappungsbereich des abisolierten Kabelendes und des PCB ein mit mit Lotüberzug bedeckten Lappen (15) (siehe Spalte 9, Zeilen 30,31) versehener Metallstreifen (44) quer zu den Leiterbahnen zwischen die übereinander gelegten Kabelende und PCB gelegt wird und an seinen überstehenden Enden mit einer steuerbaren Stromversorgung verbunden wird (siehe Fig. 2B),
b) einen Verfahrensschritt zur Herstellung von Lotverbindungen zwischen jeweils allen zu verbindenden Leiterbahnen, PCB-Kontakten (43) und Lappen (15), bei dem der Metallstreifen samt Lappen durch Strombeaufschlagung auf die Schmelztemperatur des Lotüberzuges erhitzt wird, bis sich jeweils zwischen allen zu verbindenden Leiterbahnen, PCB-Kontakten und den dazwischenliegenden Lappen (15) eine Lotverbindung gebildet hat und nach Bildung der Lotverbindung die Stromversorgung abgeklemmt wird,
c) einen abschließenden Verfahrensschritt, bei dem der Metallstreifen von den Lappen entfernt wird (siehe Spalte 7, Zeilen 44-55)".

Erfindungsgemäße Aufgabe ist es daher ein Verfahren zur Verbindung zweier Folienkabel anzugeben, bei dem Folienkabel von der Rolle verwendet werden können, und die Enden der Folienkabel verbunden werden können, ohne daß diese Enden vorkonfektioniert sind.

Erfindungsgemäß wird diese Aufgabe gelöst durch die Merkmale des unabhängigen Anspruchs. Weitere vorteilhafte Ausführungsformen sind in den Unteransprüchen enthalten.

Die Lösung gelingt demnach indem zwischen die beiden Folienkabelenden ein mit einem Lotüberzug verzinnter Metallstreifen quer über die Leiterbahnen gelegt wird, die Folienkabelenden mit dem dazwischen liegenden verzinnten Metallstreifen aufeinander gedrückt werden, der Metallstreifen mit Strom beaufschlagt und erhitzt wird, bis das Lot des Metallstreifens aufschmilzt und eine Lotverbindung mit den Leiterbahnen der Folienkabel eingeht, und nach der Lotverbindung der Metallstreifen in den Zwischenräumen zwischen zwei benachbarten Leiterbahnen durchtrennt wird.

Der mit der Erfindung hauptsächlich erzielbare Vorteil wird in der einfachen und bewährten Lotverbindung der Leiterbahnen miteinander gesehen. Lotverbindungen, insbesondere Weichlotverbindungen, lassen sich bereits bei Temperaturen unter 230 °C sicher und dauerhaft herstellen. Da die Wärmeübertragung von dem verzinnten Metallstreifen am Auflagepunkt zu den Leiterbahnen besonders groß ist, wird das Folienkabel lokal am Ort der zu verbindenen Leiterbahnen wunschgemäß besonders erhitzt. Ein großflächiges Aufschmelzen des Kunststofflaminats findet daher nicht statt und die isolierende und schützende Funktion des Kunststofflaminates bleibt auch im Verbindungsbereich der beiden Folienkabelenden erhalten.

Ausführungsbeispiele der Erfindung werden im folgenden anhand von Zeichnungen dargestellt und näher erläutert. Es zeigen:
- Fig.1: eine Explosionsdarstellung zweier Folienkabelenden mit Metallstreifen, der zumindest teilweise mit einem Lotüberzug bedeckt ist,
- Fig. 2: eine Seitenansicht der Verbindungsstelle in Schnittdarstellung
- Fig. 3: eine dreidimensionale Darstellung einer fertigen Verbindung mit Stanzlöchern zwischen den Leiterbahnen

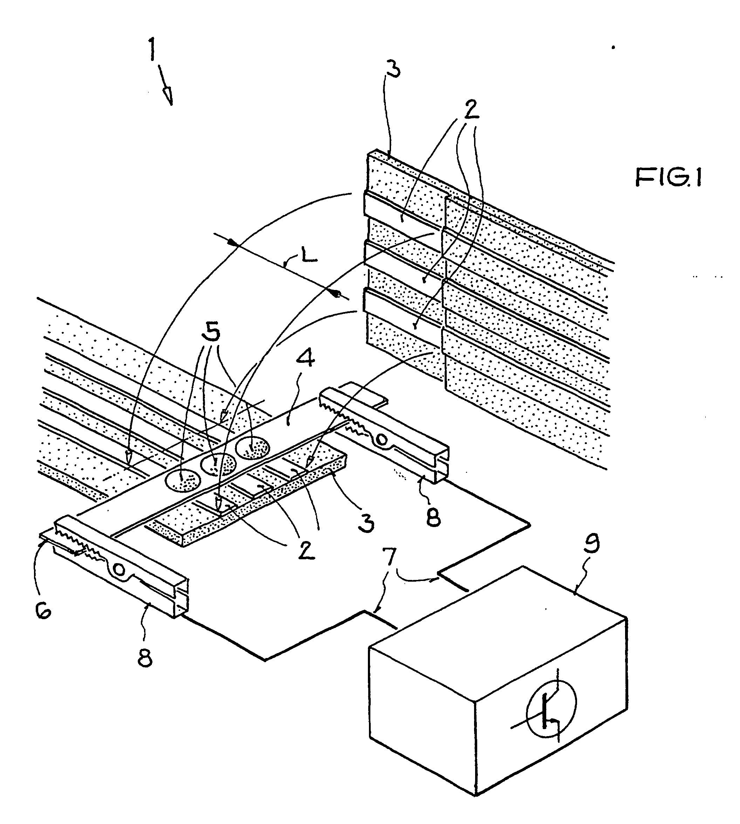

Fig. 1 zeigt zwei Folienkabelenden 1, die miteinander verbunden werden sollen. In einem mehrschichtigen Kunststofflaminat 3 sind in jedem Folienkabel eine Vielzahl von folienartigen Leiterbahnen 2 angeordnet. In dem gezeigten Ausführungsbeispiel sind in jedem Folienkabel beispielhaft 3 Leiterbahnen angeordnet. Folienkabel mit 5 oder 10 Leiterbahnen gibt es auch und können mit dem erfindungsgemäßen Verfahren ebenfalls miteinander verbunden werden. Zum Verbinden der Kabelenden müßen diese sich mit ihren Enden über eine gewisse Länge L überlappen. Für die Überlappungslänge L gibt es keine vorgegebenen Werte. Zur praktischen Handhabung haben sich Überlappungslängen im Centimeter-Bereich bewährt. Im Überlappungsbereich sind die Folienkabelenden jeweils einseitig abisoliert, so daß in diesem Überlappungsbereich die Metallstreifen mit einer freien metallischen Oberfläche aus dem Laminat herausragen. Vor dem Verbinden der Folienkäbelenden wird zwischen die zu verbindenden Kabelenden im Bereich der Überlappung ein mit einem Lotüberzug vollständig verzinnter Metallstreifen 4 gelegt. Der Metallstreifen 4 wird quer über die Kabelenden gelegt, so daß er die Leiterbahnen 2 möglichst in einem rechten Winkel kreuzt und an den Längsseiten der Kabelenden übersteht.

Wenn die Anzahl der Leiterbahnen in den Folienkabeln vorbekannt ist, kann in einer alternativen Ausführungsform der verzinnte Metallstreifen mit Lötpunkten 5 versehen sein, die den Lotüberzug des Metallstreifen entweder ersetzen oder lokal verstärken. Der Abstand der Lötpunkte 5 muß dann auf die Abstände der Leiterbahnen 2 in den Folienkabeln abgestimmt sein. Auch muß dann der verzinnte Metallstreifen 4 zwischen den Kabelenden so positioniert werden, daß die Lötpunkte 5 über den Leiterbahnen 2 zu liegen kommen.

Wenn der mit einem Lot verzinnte Metallstreifen 2 zwischen den Folienkabelenden 1 positioniert wurde, können die vorpräparierten und einseitig abisolierten Folienkabelenden formschlüssig im Überlappungsbereich übereinander gelegt und z.B. mit einer in Fig. 2 dargestellten Klemmvorrichtung fixiert werden. An den beiden überstehenden Enden 6 des Metallstreifens 4 werden in einem weiteren Verfahrensschritt Stromversorgungsleitungen 7 angebracht. Da diese Stromversorgungsleitungen nur kurzzeitig benötigt werden, werden sie praktischerweise mit einem Klemmverbinder 8 jeweils an den beiden Enden des verzinnten Metallstreifens 4 angebracht. Ein exemplarisch dargestelltes Netzgerät 9 mit integrierter Leistungselektronik dient der Stromversorgung, der Steuerung der Stromversorgung und dem Beschalten der Versorgungsleitungen.

Die weiteren erfindungsgemäßen Verfahrensschritte werden anhand von Fig. 2 erläutert. Wenn die im Zusammenhang mit Fig. 1 vorbereitenden Verfahrensschritte abgeschlossen sind, kann das eigentliche Verbinden der Folienkabelenden 1 erfolgen. In Fig. 2 sind die Folienkabelnenden 1 in einer Schnittdarstellung mit Blick von den Längsseiten der Folienkabel gezeigt. Die Leiterbahnen 2 sind in ein Kunststofflaminat 3 eingelassen. Lediglich im Überlappungsbereich der Folienkabelenden ist bei jedem Ende jeweils eine Schicht des Kunststofflaminats abgetragen, so daß die Leiterbahnen auf der verbleibenden zweiten Kunststofflaminatschicht erhaben mit einer freien abisolierten Oberfläche hervorstehen. Im Schnittbild ergibt sich dadurch ein dreischichtiger Aufbau des Folienkabels. Die Kabelenden sind entsprechend den vorbereitenden Maßnahmen formschlüssig mit einem zwischen den Kabelenden angeordneten verzinnten Metallstreifen in überlappender Weise übereinander gelegt und mit einer Klemmvorrichtung 10 fixiert.

Zum Verbinden der Leiterbahnen wird der mit Lot verzinnte Metallstreifen 4 mit Strom beaufschlagt, so daß er sich erhitzt. Zunächst wird der Metalleiter bis zur Löttemperatur des verwendeten Lotüberzugs erhitzt, bis sich zwischen den unteren und oberen Leiterbahnen 2 und dem Metallstreifen 4 jeweils eine Lotverbindung gebildet hat. Zur Unterstützung der Lotverbindung können die beiden Folienkabelenden mit einer Klemmvorrichtung 10 mit einer Kraft F aufeinander gedrückt werden. Nun kann der Stromfluß im Metallstreifen 4 wieder abgeschaltet werden, so daß die Lotverbindungen erstarren können.

In einem letzten Verfahrensschritt zu dessen Erläuterung die Fig. 3 dient, wird der Metallstreifen 4 im Bereich der die Leiterbahnen trennenden Kunststofflaminatabschnitte durch Ausstanzungen 11 durchtrennt, und die an den Längsseiten überstehenden Enden des Metallstreifens 4 abgetrennt. Da der Metallstreifen 4 nach erfolgter Lotverbindung die einzelnen Leiterbahnen 2 des Folienkabels auch in Querrichtung überbrückt und damit kurzschließt, muß dieser Kurzschluß zwischen den Leiterbahnen wieder aufgehoben werden. Hierzu durchtrennt man den Metallstreifen an geeigneter Stelle zwischen den Leiterbahnen, z.B. durch Einstanzen von Ausnehmungen. Die Stanzwerkzeuge sind nicht dargestellt. Zweckmäßiger Weise sind die Stanzwerkzeuge bereits in der in Fig. 2 dargestellten Klemmvorrichtung 10 integriert.

## Patentansprüche

1. Verfahren zum Verbinden zweier Folienkabelenden (1), bei denen in einem Kunststofflaminat (3) eine Vielzahl von folienartigen Leiterbahnen (2) angeordnet sind, umfasssend:
a) einen vorbereitenden Verfahrensschritt, bei dem im Überlappungsbereich (L) der beiden einseitig abisolierten Folienkabelenden (1) ein mit einem Lotüberzug (5) zumindest teilweise bedeckter Metallstreifen (4) quer zu den Leiterbahnen (2) zwischen die formschlüssig übereinander gelegten Folienkabelenden (1) gelegt wird und an seinen überstehenden Enden mit einer steuerbaren Stromversorgung (9) verbunden wird,
b) einen Verfahrensschritt zur Herstellung von Lotverbindungen zwischen jeweils allen zu verbindenden Leiterbahnen (2) und dem Metallstreifen (4), bei dem der Metallstreifen (4) durch Strombeaufschlagung auf die Schmelztemperatur des Lotüberzuges (5) erhitzt wird, bis sich jeweils zwischen allen zu verbindenden Leiterbahnen (2) und dem dazwischenliegenden Metallstreifen (4) eine Lotverbindung gebildet hat und nach Bildung der Lotverbindung die Stromversorgung (9) abgeklemt wird,
c) einen abschließenden Verfahrensschritt, bei dem der Metallstreifen (4) im Bereich der die Leiterbahnen (2) trennenden Kunststofflaminatabschnitte durchtrennt wird.

2. Verfahren nach Anspruch 1, **dadurch gekennzeichnet, daß** im abschließenden Verfahrensschritt der Metallstreifen (4) im Bereich der die Leiterbahnen trennenden Kunststofflaminatabschnitte durch Ausstanzungen (11) durchtrennt wird.

3. Verfahren nach Anspruch 1 oder 2, **dadurch gekennzeichnet, daß** der Metallstreifen (4) vollständig mit einem Lotüberzug (5) bedeckt ist.

4. Verfahren nach Anspruch 1 oder 2, **dadurch gekennzeichnet, daß** der Metallstreifen (4) lediglich teilweise mit Lötpunkten (5) bedeckt ist.

5. Verfahren nach einem der Ansprüche 1 bis 4, **dadurch gekennzeichnet, daß** die Folienkabel sogenannte Flat Laminated Cabels (FLC) sind.

## Claims

1. Method for the connection of two flat laminated cable ends (1), wherein a plurality of foil-type conductors (2) is arranged in a plastic laminate (3), comprising:
a) a preparatory step, whereby a metal strip (4) at least partially covered by a solder coating (5) is placed between the flat laminated cable ends (1) positively superimposed on one another at right angles to the conductors (2) in the overlap region (L) of the two one-sidedly stripped flat laminated cable ends (1) and connected to a controllable power supply (9) at its projecting ends,
b) a step for the establishment of soldered connections between all conductors (2) to be connected and the metal strip (4), whereby the metal strip (4) is heated by the application of a current to the melting temperature of the solder coating (5) until a soldered connection is formed between all conductors (2) to be connected and the metal strip (4) lying between them, and whereby the power supply (9) is disconnected when the soldered connection has been established,
c) a concluding step, whereby the metal strip (4) is cut through in the region of the plastic laminate sections separating the conductors (2).

2. Method according to claim 1, **characterised in that** the metal strip (4) is cut through in the region of the plastic laminate sections separating the conductors by punchings (11) in the concluding step.

3. Method according to claim 1 or 2, **characterised in that** the metal strip (4) is completely covered by a solder coating (5).

4. Method according to claim 1 or 2, **characterised in that** the metal strip (4) is partially covered by solder spots (5).

5. Method according to any of claims 1 to 4, **characterised in that** the cables are so-called flat laminated cables (FLC).

## Revendications

1. Procédé de connexion de deux extrémités de câbles en films (1) dans lesquelles une pluralité de pistes conductrices semblables à des films (2) est disposée dans un stratifié en matière plastique (3), comprenant :
a) une étape de procédé de préparation, dans laquelle, dans la zone de chevauchement (L) des deux extrémités de câbles en films (1) isolées d'un côté, une bande métallique (4) recouverte au moins partiellement par une couche de brasure (5) est posée perpendiculairement aux pistes conductrices (2) entre les extrémités de câbles en films (1) posées les unes sur les autres de manière solidaire et est raccordée, à ses extrémités en saillie, à une alimentation électrique que l'on peut commander (9),
b) une étape de procédé de fabrication de jonctions par brasage entre toutes les pistes conductrices à raccorder (2) et la bande métallique (4), dans laquelle la bande métallique (4) est réchauffée à la température de fusion de la couche de brasure (5) par alimentation du courant électrique jusqu'à ce qu'une jonction par brasage se forme entre toutes les pistes conductrices à raccorder (2) et la bande métallique (4) placée entre elles et l'alimentation électrique (9) est déconnectée après la formation de la jonction par brasage,
c) une étape de procédé finale dans laquelle la bande métallique (4) est séparée dans la zone des portions de stratifié en matière plastique séparant les pistes conductrices (2).

2. Procédé selon la revendication 1, **caractérisé en ce que**, dans l'étape de procédé finale, la bande métallique (4) est séparée par des découpes à la matrice dans la zone des portions de stratifié en matière plastique séparant les pistes conductrices (2).

3. Procédé selon la revendication 1 ou 2, **caractérisé en ce que** la bande métallique (4) est entièrement recouverte d'une couche de brasure (5).

4. Procédé selon la revendication 1 ou 2, **caractérisé en ce que** la bande métallique (4) est simplement partiellement recouverte de points de brasure (5).

5. Procédé selon l'une quelconque des revendications 1 à 4, **caractérisé en ce que** les câbles en films sont ce que l'on appelle des Flat Laminated Cables (FLC) (câbles plats à isolation stratifiée).
